# EUROPEAN PATENT SPECIFICATION

(11) **EP 4 179 341 B1**
(45) Date of publication and mention of the grant of the patent: **03.09.2025**
(21) Application number: 20743347.5
(22) Date of filing: 13.07.2020
(51) Int. Cl.: G01R 29/08, H01Q 17/00

(54) **REMOVABLE FASTENER FOR ANECHOIC MATERIAL**
ABNEHMBARE BEFESTIGUNGSVORRICHTUNG FÜR ECHOFREIES MATERIAL
ÉLÉMENT DE FIXATION AMOVIBLE DE MATÉRIAU ANÉCHOÏQUE

(43) Date of publication of application: 17.05.2023
(73) Proprietor: Telefonaktiebolaget LM Ericsson (publ), 164 83 Stockholm (SE)
(72) Inventor: PULEJO, Gino, Plano, Texas 75025 (US); NEGRICH, Dennis, Allen, Texas 75013 (US); LEBLANC, Douglas, Plano, Texas 75074 (US); RIDGWAY, Philip, Allen, Texas 75002 (US); HESTER, Melissa, Flower Mound, Texas 75028 (US)
(74) Representative: Ericsson
(86) International application number: PCT/IB2020/056577
(87) International publication number: WO 2022/013595

(56) References cited:
- EP-A1- 0 762 540
- DE-A1- 4 026 403
- DE-A1- 4 327 284
- JP-A- H0 544 273
- JP-A- H10 275 996
- US-A- 5 238 342
- US-A- 5 510 792
- US-A1- 2019 345 723

## Description

### TECHNICAL FIELD

Embodiments of the invention relate to the field of wireless communication device testing; and more specifically, to the design of enclosures for the testing of wireless devices and the configuration of enclosures for the testing of wireless devices.

### BACKGROUND ART

Testing of electronic devices with wireless communication capabilities (e.g., use of radio frequency spectrum) can be facilitated by isolation from ambient signals and by an environment with minimal signal reflection or refraction. Testing structures with these properties are utilized for testing the wireless capabilities of these electronic devices. Anechoic chambers are examples of testing structures for these electronic devices. Anechoic chambers are designed as enclosed rooms whereby specialized material designed for attenuation of signals (i.e. radio frequency signals) can be used as a surface covering to allow an enclosed room to emulate, or attempt to approximate, the characteristics of free space by mitigating unwanted signal reflections as a consequence of being in an enclosed room.

Testing structures such as anechoic chambers serve as an isolated environment to allow for controlled testing of the wanted signals within the testing structure. This type of testing is especially useful and necessarily required for testcases where live over the air transmission of the wanted signals is required either as a direct consequence of the technology (i.e. cabling interfaces are not allowed between devices under test such as for 5G testing) or utilization of unlicensed radio spectrum is required and therefore must be contained. The specialized material for covering the interior surfaces of such an environment is referred to as anechoic material (also known as, for example, absorbers, microwave absorbers, acoustic absorbers, anechoic foam, and similar terms). Existing methods for installing anechoic material in such a testing structure typically requires the use of adhesives such as glue, epoxy, silicon, Velcro, tape, or other more involved processes such as a clip and rail systems. These methods for preparing a testing structure make reconfiguration or reassembly difficult as the adhesives and other mechanisms damage the anechoic material rendering it ineffective for reuse. Different ways of attaching anechoic materials onto the walls of anechoic chambers can be seen in EP 0 762 540 A1, US 5 510 792 A, DE 43 27 284 A1 and in JP H10 275996 A.

### SUMMARY

The invention is defined by a system according to claim 1 and a method for manufacturing the system according to claim 11. Further aspects are defined by the corresponding dependent claims.

### BRIEF DESCRIPTION OF THE DRAWINGS

The invention may best be understood by referring to the following description and accompanying drawings that are used to illustrate embodiments of the invention. In the drawings:
Figure 1A is a diagram of one embodiment of a removable fastener coupled with an attachment mechanism.
Figure 1B is a diagram of one embodiment of a removable fastener and insertion of an attachment mechanism.
Figure 2 is a diagram of one embodiment of a removable fastener where the attachment mechanism is housed within the removable fastener.
Figure 3 is a diagram of the one embodiment of a removable fastener with a cross-shaped retention mechanism.
Figure 4 is a diagram showing a cross-section view of one embodiment of an anechoic material substrate attached to a testing structure utilizing a set of removable fasteners.
Figure 5 is a diagram showing a top view of one embodiment of an anechoic material substrate having a set of removable fasteners.
Figure 6 is a diagram of one embodiment of a testing structure including a set of anechoic material substrates attached via removable fasteners.
Figure 7 is a flowchart of one embodiment of a process for manufacturing and deploying a removable fastener.
Figure 8A is a diagram that illustrates a side view of a tine extender.
Figure 8B is a diagram that illustrates a top/bottom view of the tine extender.
Figure 8C is a diagram that illustrates a cross-section of the tine extender.
Figure 8D is a diagram of a set of removable fasteners coupled by a tine extender.

### DETAILED DESCRIPTION

The following description describes a removable fastener to attach anechoic material to a testing structure. In the following description, numerous specific details such as logic implementations, opcodes, means to specify operands, resource partitioning/sharing/duplication implementations, types and interrelationships of system components, and logic partitioning/integration choices are set forth in order to provide a more thorough understanding of the present invention. It will be appreciated, however, by one skilled in the art that the invention may be practiced without such specific details. Those of ordinary skill in the art, with the included descriptions, will be able to implement appropriate functionality without undue experimentation.

References in the specification to "one embodiment," "an embodiment," "an example embodiment," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described.

Bracketed text and blocks with dashed borders (e.g., large dashes, small dashes, dot-dash, and dots) may be used herein to illustrate optional operations that add additional features to embodiments of the invention. However, such notation should not be taken to mean that these are the only options or optional operations, and/or that blocks with solid borders are not optional in certain embodiments of the invention.

In the following description and claims, the terms "coupled" and "connected," along with their derivatives, may be used. It should be understood that these terms are not intended as synonyms for each other. "Coupled" is used to indicate that two or more elements, which may or may not be in direct physical or electrical contact with each other, co-operate or interact with each other. "Connected" is used to indicate the establishment of communication between two or more elements that are coupled with each other.

The construction of testing structures in the art relies on the use of adhesives and similar mechanisms for attaching anechoic materials to the testing structure. The problem with using adhesives and similar mechanisms for attaching anechoic material to a surface of a testing structure is that adhesives and similar mechanisms are typically a one-time application and/or requires a clean-up/removal of the adhesives from the testing structure surfaces. Removing the adhesives or similar mechanisms from anechoic materials can also damage the anechoic material rendering it ineffective. In addition, using adhesives or similar mechanisms to attach anechoic material to testing structures prevents any changes from being made to the configuration once the anechoic materials are set in place. Adhesives also damage the anechoic material after the adhesives have set as the material may tear upon removal of the adhesive or during separation of the anechoic material from the testing structure. Therefore, installing anechoic material using adhesives and similar mechanisms requires precision placement the first time. Removing or rearranging anechoic material relative to the testing structure for any reason after initial placement could require additional purchase of anechoic material to replace any pieces that may be damaged as a result of the removal of the adhesives or similar mechanisms used.

The embodiments provide a removable fastener that is designed to be installed from the front side of the anechoic material through a substrate of the anechoic material. The substrate of the anechoic material can have any shape or design suitable for attenuating the signaling to be tested. In some example embodiments, a square pyramidal anechoic material is utilized. The removable fastener can include a retention mechanism to interface with one surface of the anechoic material. In one example, the retention mechanism is a set of tines. A 'set,' as used herein can be any whole number of items including one item. The removable fastener also includes an attachment mechanism. In one example, the retention mechanism is a magnet. The retention mechanism and attachment mechanism together are designed to hold the anechoic material in place against a surface of a testing structure. The embodiments of the removable fastener can have any length or shape. The length and shape of the removable fastener can be dependent on the design of the anechoic material that is utilized. The embodiments of the removable fastener can be equipped with a strong attachment mechanism such as a magnet (e.g. a neodymium magnet) to ensure maximum holding strength using a minimum amount of space.

The embodiments overcome these defects of the cited art. The removable fastener can be added and removed from the anechoic material with ease without the need for the additional removal and/or clean-up required of adhesives. The removable fastener also does not damage the anechoic material. The removable fastener has the advantage of also not requiring the complication and cost of the installation of a substructure to attach to as is the case with a clip and rail system. In some embodiments, the removable fastener is equipped with a detachment mechanism. In one example embodiment, a loop on the topside of a base of the removable fastener is included such that the removable fastener can be more easily removed, for example, using a tool equipped with a small hook, the use of pliers, or a similar tool. In some embodiments, a specialized tool is not required. The removable fastener can be detached from the test structure manually. For example, a technician could use their fingers to grip below the tines to remove the fastener if no tools are readily available.

The advantage of the embodiments is the ease by which anechoic material can be added or removed to a testing structure without the added collateral damage imposed on the anechoic material itself or the necessary removal, clean-up, and reapplication of new adhesives to the surfaces of the testing structure as well as the anechoic material. In many testing scenarios, there can be a need to remove and reposition anechoic material as a consequence of evolving test cases that require different frequencies to be tested (and thus different Anechoic material to match the specifications) or the need to reconfigure/relocate portions of the anechoic material or the entire testing structure. In such cases, the ability to remove, protect, and transport anechoic material for reinstallation is vitally important as damage to the anechoic material (in particular, the tips) could render the anechoic material ineffective for future testing thus forcing the replacement/purchase of new anechoic material at additional cost.

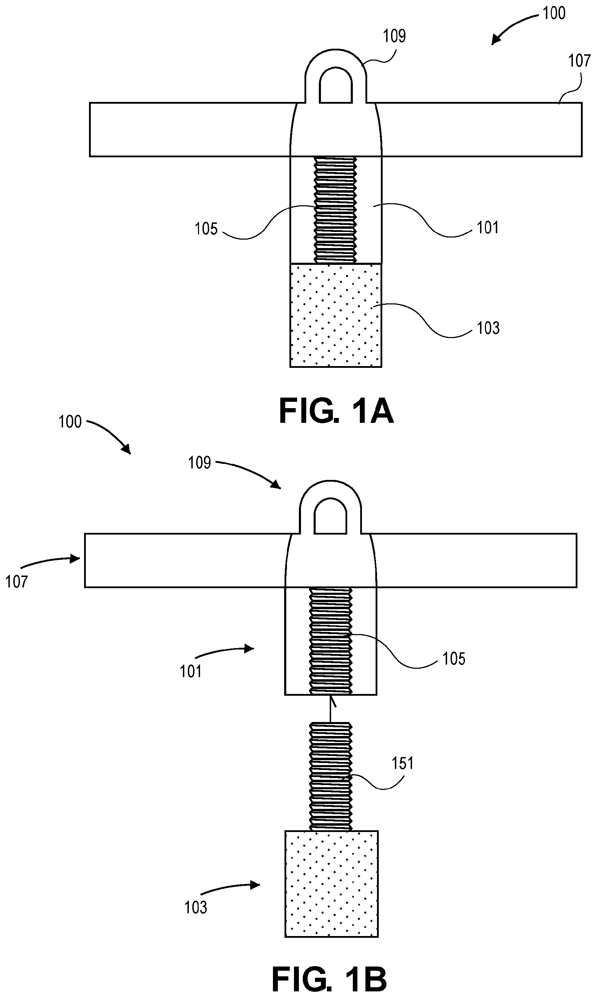

Figure 1A is a diagram of one embodiment of a removable fastener. The removable fastener 100 can include a base 101, attachment mechanism 103, and retention mechanism 107. In some embodiments, the removable fastener 100 can include a detachment mechanism 109. The base 101 can be formed of any natural, synthetic, or other material including, plastics, resins, metals, and similar materials. In some embodiments, the material of the base 101 can be selected and shaped to match the anechoic material used. The examples herein illustrate an embodiment, where the removable fastener is designed to support square base pyramidal tip anechoic material. However, one skilled in the art would appreciate that the principles and structures described herein are applicable with other anechoic material shapes and structures. The base 101 can have any length, diameter, or shape. The base 101 can have a primarily hollow or solid interior. In the example embodiments, the base 101 has a roughly conical structure. However, the base 101 can have a rectangular, polygonal, irregular, or other shape.

The retention mechanism 107 is coupled to the base 101 and provides a gripping mechanism for holding the anechoic material against a ferrous surface. The shape, length, and number of tines can be dependent on the anechoic material chosen for the application. The cross-shaped embodiment is provided by way of example and not limitation. The cross-shaped retention mechanism 107 in the example is designed for use with a square base pyramidal tip anechoic material. In other embodiments, the retention mechanism 107 can include additional tines or have an alternate shape such as a flat circular, square, polygonal, spherical, spoke and wheel or other shape that provides a surface to grip or press on the substrate of anechoic material. The retention mechanism 107 can be formed of the same material as the base 101 or a different material. The retention mechanism can be any material including a natural material or synthetic material such as plastic, resin, metal, or similar material. The retention mechanism 107 can be formed as a single unitary structure with the base 101 or can be a separate structure attached to the base 101 by any coupling mechanism. The retention mechanism 107 can be attached by adhesives, screws, complementary threading, or any similar coupling mechanism.

The attachment mechanism 103 is a mechanism to enable the removable fastener 100 to be removably attached to a testing structure. 'Removable' as used herein refers to a capability to be detached without materially changing the fastener or the object that the fastener is being attached to. In some embodiments, the attachment mechanism 103 can be a magnet. The magnet can be formed of a rare earth material, e.g., neodymium. The size and strength of the magnet can be selected to be capable of securing a portion (i.e., a specific percentage) of a substrate of the anechoic material. In other embodiments, other similar attachment mechanisms can be utilized including magnets, electro-magnets, suction cups, or similar mechanisms. In some embodiments, the magnet can be selected to have a strength capable of securing at least 25% of the substrate of anechoic material or an approximate 12 inch by 12 inch by 4 inch section of anechoic material. The amount of anechoic material secured can be directly related to the length of the retention mechanism 107. Longer tines could allow more of the anechoic material to be secured with fewer removable fasteners 100 overall.

In some embodiments, the base 101 defines a threaded shaft 105 or similar coupling mechanism. The use of a threaded shaft 105 provides a mechanism for attachment mechanism 103 (e.g., magnets) with integrated threads to be attached to the base 101. The coupling mechanism 105 by which an attachment mechanism 103 can be coupled to the base 101 is not limited to the use of a threaded shaft 105. Other methods for incorporating an attachment mechanism 103 into the base 101 could include, but are not limited to, for example, a captive solution whereby a magnet or similar attachment mechanism 103 is encapsulated in the base 101 of the removable fastener 100 as a single self-contained removable fastener design. Where threaded shafts 105 are utilized as part of the removable fastener, the use of threaded inserts (i.e. a separate threaded insert structure with a knurled exterior surface) can be incorporated depending on the manufacturing process chosen. In some embodiments, the threaded insert structure is formed from brass or similar material.

In some embodiments, the removable fastener includes a detachment mechanism 109. The detachment mechanism 109 can be a loop, hook, grip, or similar structure that enables a tool to engage with the removable fastener to easily remove the removable fastener from a testing structure. In some embodiments, the detachment mechanism 109 can include moving components to reposition the base 101 or attachment mechanism relative to the testing structure. For example, the detachment mechanism 109 can be a button or toggle to disengage an electro-magnet, a slide to move the attachment mechanism 103 further from the testing structure thereby disengaging (e.g., moving a magnet of the removable fastener away from a testing structure to weaken the magnetic connection) or similar mechanism. The detachment mechanism 109 can be used in any manner for removal of the removable fastener 100 from a testing structure once the removable fastener 100 is set in place.
Figure 1B is a diagram of one embodiment of a removable fastener and the insertion of the attachment mechanism. In this embodiment, the removable fastener 100 has a 2-piece construction including a base 101 defining a threaded shaft 105. The attachment mechanism 103 also has threaded shaft 151 attached to, for example, a magnet. The threaded shaft 151 can be coupled with or integral to the magnet. Assembly of this embodiment involves the insertion and rotation of the threaded shaft 151 coupled to the magnet 103 into the base 101.

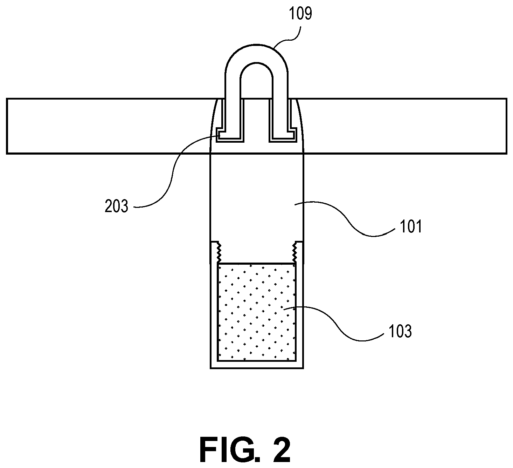

Figure 2 is a diagram of another embodiment of a removable fastener. In this embodiment, the removable fastener 100 includes an attachment mechanism 103 that is internal to the base 101. For example, the attachment mechanism 103 can be a captive magnet within the base 101. The base 101 can be formed into sections that interlock via threading, form fit (e.g., with knurled surfaces of the base 101 and/or the attachment mechanism 103), or similar interface. In another embodiment, the base 101 can have an open end or partially open end that enables insertion of the attachment that is held in place by form fit, or similar coupling mechanism.

In this embodiment of the removable fastener 100, the detachment mechanism 109 can similarly be attached via a coupling mechanism 203. The coupling mechanism 203 can be complementary threading, form fit (e.g., knurled surfaces), or similar coupling mechanism. In other embodiments, the detachment mechanism 109 can be integrally formed with the base 101 (e.g., as shown in Figures 1A and 1B). In the illustrated example, the detachment mechanism 109 is a form fitting clip or interlocking surfaces configuration. One skilled in the art would appreciate that other similar coupling mechanisms can be utilized in embodiments where the detachment mechanism 109 is not a form fit.

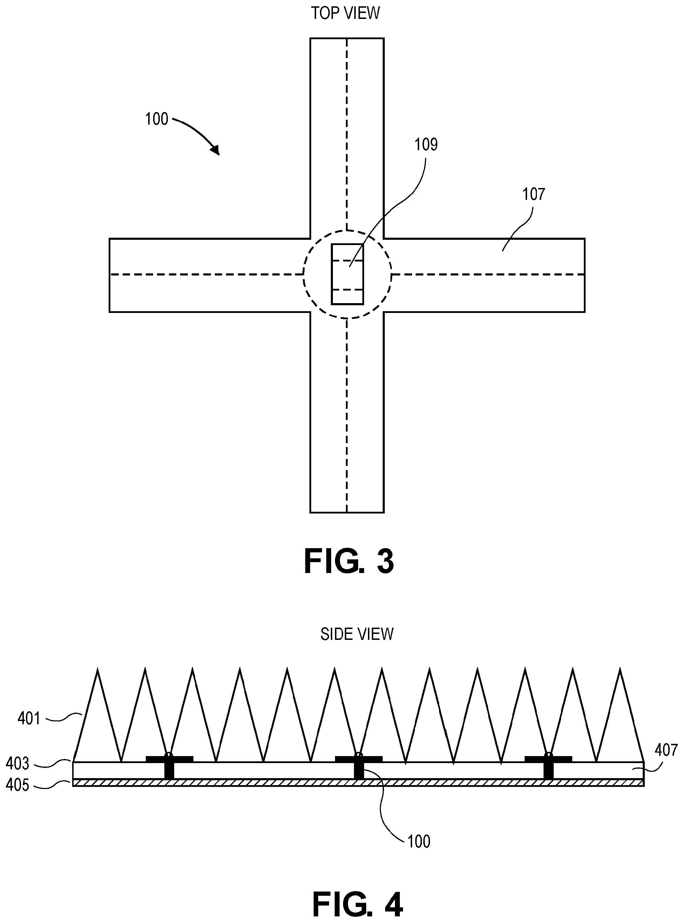

Figure 3 is a diagram of the one embodiment of a removable fastener with a cross-shaped retention mechanism. In one embodiment, the removable fastener 100 can include a retention mechanism 107. In the example embodiment illustrated, the retention mechanism 107 has a cross-shape with four tines at right angles to one another. Each tine in this example has a square or diamond cross section where an edge or corner is positioned at a bottom position. This retention mechanism 107 is provided by way of example and not limitation, other patterns and configurations of the retention mechanism that can engage an anechoic material substrate without distorting or damaging the anechoic material substrate can be utilized. The shape of the retention mechanism 107 can be complementary to a surface of the anechoic material substrate.

Figure 4 is a diagram of one embodiment of an anechoic material substrate that is attached to a testing structure utilizing removable fasteners 100. In the illustrated example, a substrate of anechoic material 403 is illustrated. The substrate of anechoic material 403 includes a base 407 and a shaped section 401. The base 407 can have any thickness or size. The base 407 can have holes or vias defined therein to receive the removable fastener 100. The holes or vias can be any size or shape complementary to the shape of the removable fastener. The shaped section 401 can have any shape or size selected to attenuate signals to facilitate the desired testing. In the illustrated example, the shaped section 401 includes a set of anechoic pyramids. The pyramids can have any length, width, or breadth. The shaped section can have a uniform pattern or can have a varied pattern of structures dependent on the testing requirements.

In some embodiments, the base 407 and the shaped section 401 can be formed as a unitary structure. In other embodiments, the shaped section 401, base 407, and any other section of the substrate of anechoic material 403 can be formed as unitary components or can be broken up into any number of sub-components for assembly. The anechoic materials of the substrate 403 can be assembled via adhesives, interlocking structures, custom sized or designed, or similarly assembled.

The anechoic material substrate 403 can rest against a surface 405 of a testing structure. The surface 405 can be formed of any material and have any size or shape. In one embodiment, the surface 405 includes a ferrous material to which a magnet in the removable fastener 100 can attach. The surface 405 can be a flat plane, an uneven, porous surface, such as a mesh or cut outs, with contact points for engaging the removable fasteners 100.

In one example, the anechoic material substrate 403 can be a 2' x 2' square. The removable fasteners are placed on the 2' x 2' square of anechoic material using a square base pyramid tip design. The removable fasteners 100 can be spaced 1" apart or similarly spaced. The spacing can be determined based on the load that each removable fastener can bear as well as the weight of the anechoic material substrate 403. A ratio of removable fasteners 100 to anechoic material substrate 403 can then be determined and spacing can be a function of the ratio.

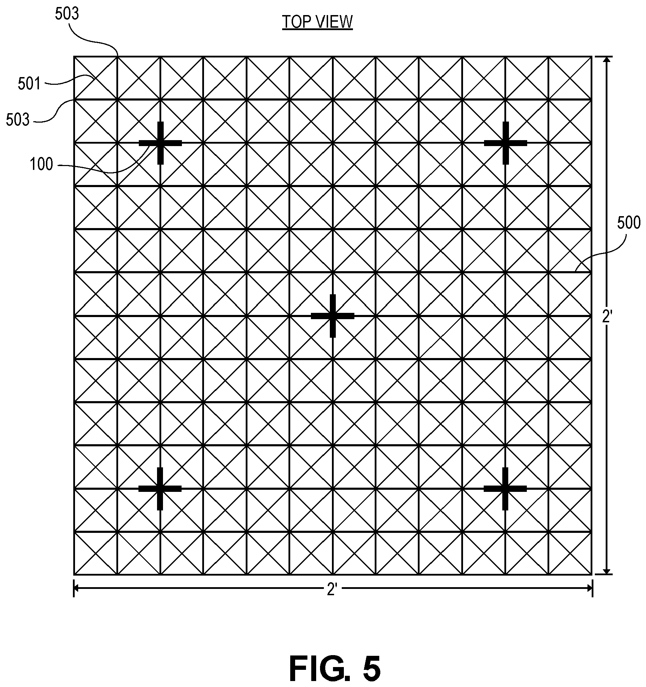

Figure 5 is a diagram of one embodiment of an anechoic material substrate having a set of removable fasteners. In this example, removable fasteners 100 are placed within an anechoic substrate 500. In this example, the anechoic substrate 500 is a 2' x 2' square of anechoic material using a square base pyramid tip design. The number and location of each removable fastener 100 can be determined based on a type, weight, size, density, and other properties of the anechoic material in the substrate 500. In this example, five removable fasteners 100 are utilized to hold the substrate 500. The removable fasteners are positioned in low points 503 adjacent to the base of the substrate 500, between the high points 501 of the pyramids. The retention mechanisms of the removable fasteners 100 are designed to sit in the low points 503 and engage with the substrate 500 outer surface in the low points 501 at an even spacing. Component 100 seen in this view is the Anechoic Material Retainer.

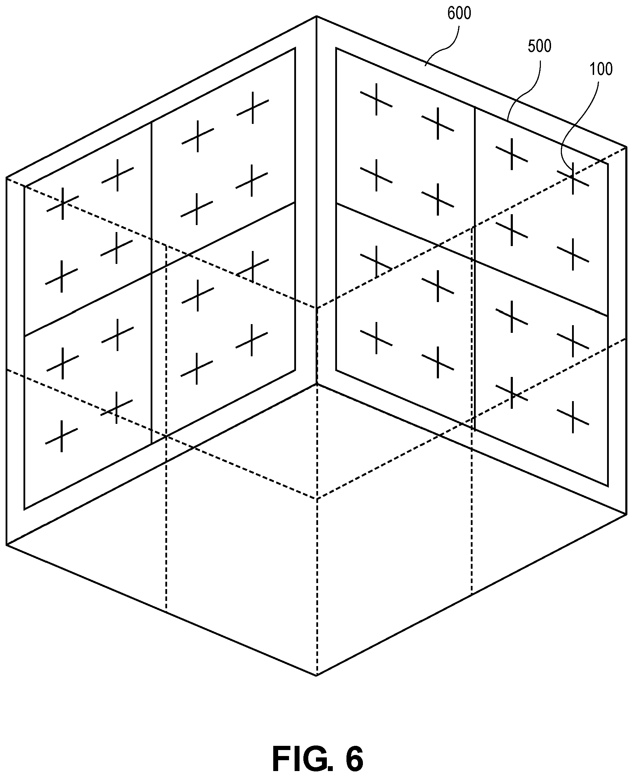

Figure 6 is a diagram of one embodiment of a testing structure including a set of anechoic material substrates attached via removable fasteners. The testing structure 600 in this example is a cubic enclosure with six sides having flat surfaces against which the anechoic substrates are pinned by the removable fasteners 100. This testing structure 600 is provided by way of example and not limitation. The testing structure 600 can have any shape of configuration such that surfaces or contact points are presented for attaching anechoic material substrates 500 to the testing structure 600 using removable fasteners 100. The anechoic material substrate 500 can be sectioned into any size or combination of individual substrates that are pinned or anchored by any number of removable fasteners 100 such that the strength of the removable fasteners is sufficient to hold a weight of the anechoic material substrate section.

The testing structure 600 can have any size or shape sufficient to hold electronic devices to be tested. The testing structure 600 can include other structures for holding, interacting with, or otherwise managing the electronic devices to be tested such as test beds, holders, wiring, and similar components. The testing structure can be formed from any material or combination of materials. In some embodiments, surfaces or contact points upon which the anechoic material is to be mounted using the removable fasteners 100 can be formed of ferrous material such that a magnet of the removable fastener 100 can be utilized to mount the removable fastener to the testing structure and to hold the anechoic material substrate.

The operations in the flow diagrams will be described with reference to the exemplary embodiments of the other figures. However, it should be understood that the operations of the flow diagrams can be performed by embodiments of the invention other than those discussed with reference to the other figures, and the embodiments of the invention discussed with reference to these other figures can perform operations different than those discussed with reference to the flow diagrams.

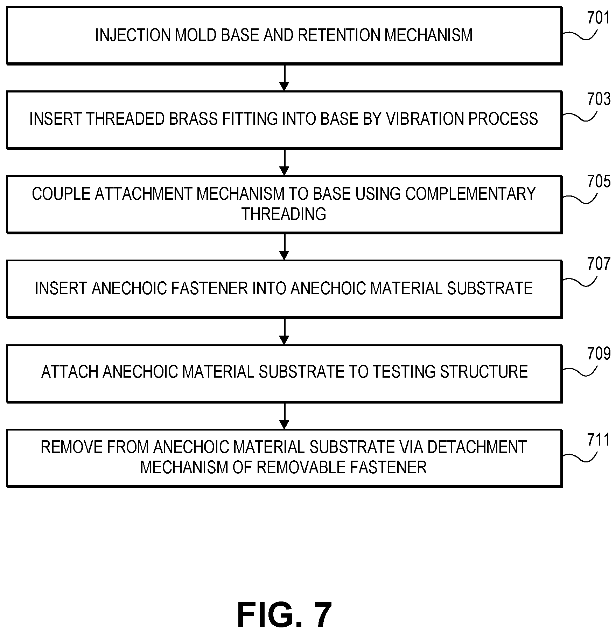

Figure 7 is a flowchart of one embodiment of a process for manufacturing and deploying a removable fastener. In one embodiment, the removable fasteners described herein can be manufactured and deployed in the manner illustrated. However, the example method of manufacture is provided by way of illustration and not limitation. The removable fastener can be manufactured and utilized using other methods and processes.

In the example process, the base and retention can be injection molded (Block 701). The base and retention mechanism can be injection molded as a unitary component or separately injection molded and later assembled. The materials utilized can be any suitable for an injection molding process including any natural material or synthetic material such as plastic, resin, metal, and similar materials. In some embodiments, the base can be molded with internal threading or similar retention mechanism. In the illustrated example, a separate brass fitting is inserted into the base by a vibration process (Block 703). The brass fitting and/or the internal walls of the base can have a knurled surface to improve the bonding strength between the surfaces. The brass fitting can provide threading to interface with an attachment mechanism. The brass fitting thereby provides a coupling mechanism between the base and the attachment mechanism. The attachment mechanism can thereby be attached to the removable fastener (Block 705). The attachment mechanism can be added by use of the complementary threading where the attachment mechanism has a threaded shaft.

With the attachment mechanism secured, the removable fastener can be deployed. The removable fastener can be inserted into a hole or via of the anechoic material substrate (Block 707). Insertion of the removable fastener and contact with a testing structure can attach the removable fastener to the testing structure thereby holding the anechoic material substrate against the testing structure (Block 709). If the removable fastener needs to be repositioned or removed, then the detachment mechanism of the removable fastener can be utilized (Block 711). For example, where the detachment mechanism is a loop, then a hook or similar tool can be utilized. In other embodiments, a button or similar mechanism can disengage the removable fastener.

The removable fastener is used as a mechanism to attach anechoic material directly to a surface of a testing structure without the need for adhesives or the installation of a separate substructure to attach to. Used with a testing structure and a combination of other removable fasteners and anechoic material substrates, the installation of each removable fastener starts with identifying precisely where the installer would like to place each removable fastener on each substrate of anechoic material. In some embodiments, a sharp object (e.g., a pick, screwdriver, or similar device) can be used to start a hole from the front of the anechoic material to the back. This ensures that the removable fastener sits exactly where desired on the overall surface of the anechoic material as well as being at the low point (i.e. base), for example, between the pyramidal (or similar) anechoic protrusions. This process is repeated for each location on a piece of anechoic material as desired as part of installation. The quantity, characteristics, and location of the removable fasteners should be determined such as to provide the desired holding strength and overall appearance. For example, it may be desired to have more removable fasteners for holding ceiling material in place vs. wall material. In some embodiments, tine extenders can be used for ceiling material or other placements that are more difficult to retain. This is to help reduce deflection of the material as a result of gravity pulling down on it from the ceiling. Once all removable fasteners are situated on a substrate of anechoic material where desired, the installer will bring the rear side of the anechoic material near to the ferrous surface of the testing structure where the attachment mechanism (e.g., magnets) in the base of each removable fastener will affix the entire substrate of anechoic material as required directly at the desired location and orientation on the surface of the testing structure. This process is repeated until all surfaces are covered with the desired number of anechoic material pieces as required for the testing structure.

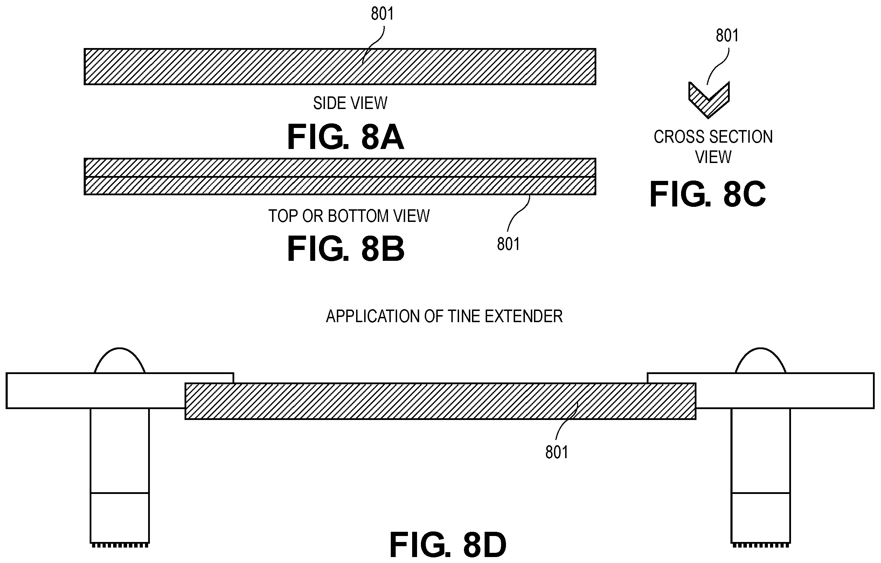

Figures 8A - 8D are diagrams of one embodiment of a tine extender. In this embodiment, one or more tine extenders 801 can be coupled to the retention mechanism to enable two or more removable fasteners to be connected. In Figure 8A the tine extender 801 has a shape that is complementary to the tines to interlock with the tines via a form fit. The tine extender 801 can have any shape or length to enable any spacing of removable fasteners. The tine extender 801 can be coupled to the removable fastener using any mechanism including form fit, complementary shapes, clasps, fasteners, or similar mechanisms. In some embodiments, the removable fastener can include an integrally formed tine extender to enable coupling with other removable fasteners. The example of the diagrams is provided by way of example and not limitation. One skilled in the art can apply the principles, features, and structures to other implementations of the tine extenders.

In Figure 8A the diagram illustrates a side view of the tine extender 801 that has a roughly rectangular profile. In Figure 8B the diagram illustrates a top/bottom view that illustrates that the tine extender 801 defines a channel that is complementary in shape to the tine. In Figure 8C the diagram illustrates a cross-sectional view of the tine extender 801 that demonstrates the 'V' shape of the cross-section. In Figure 8D the diagram illustrates a coupling of two removable fasteners using the tine extender 801. In the illustrated example the tine extender 801 fits below the respective tines of each removable fastener. In use, the tine extender 801 is held in position between the tines and the anechoic material in this embodiment. The tine extender 801 can enable the placement of the removable fasteners to be further apart by providing an additional surface for retaining the anechoic material.

The foregoing embodiments present a removable fastener that can effectively and directly hold a substrate of anechoic material in place without the need for adhesives, Velcro, or complicated apparatus's, as a separate substructure to attach to. The use of a magnet combined with the concept of a retention mechanism such as tines to hold the anechoic material against a ferrous or similar surface of a testing structure is practical, and effective for testing.

For example, while the flow diagrams in the figures show a particular order of operations performed by certain embodiments of the invention, it should be understood that such order is exemplary (e.g., alternative embodiments may perform the operations in a different order, combine certain operations, overlap certain operations, etc.).

The invention is defined by the appended claims.

## Claims

1. A system comprising:
anechoic material forming a substrate;
a testing structure (600) formed of a ferromagnetic material; and
an apparatus (100) removably coupled to the anechoic material (500), the apparatus disposed through the anechoic material to hold the anechoic material to a ferrous surface, the apparatus comprising a base (101);
a retention mechanism (107) coupled to the base; and
an attachment mechanism (103) coupled to the base, the attachment mechanism to removably attach the apparatus to a ferrous wall,
wherein the retention mechanism and the attachment mechanism together are designed to hold the anechoic material in place against a surface of the testing structure.

2. The system of claim 1, further comprising:
a detachment mechanism (109) coupled to the base.

3. The system of claim 1, wherein the attachment mechanism is a magnet.

4. The system of claim 1, wherein the retention mechanism is a set of tines having a cross shape centered at the base.

5. The system of clam 4, further comprising:
a tine extender coupled to at least one tine in the set of tines, the tine extender to enable the apparatus to be coupled to a tine of another apparatus.

6. The system of claim 1, wherein the base and retention mechanism are formed of a nonferrous material.

7. The system of claim 1, wherein the base defines threading to receive the attachment mechanism.

8. The system of claim 1, wherein the base defines a space to hold the attachment mechanism internal to the base.

9. The system of claim 1, wherein the base is conical with a rounded dome at one end.

10. The system of claim 2, wherein the detachment mechanism is a loop coupled to the base.

11. A method of manufacturing the system of the preceding claims, the method comprising:
forming the base (101) and retention mechanism (107) by injection molding.

12. The method of manufacturing the system of claim 11, further comprising:
inserting a threaded brass structure into an interior space of the base by vibration process.

13. The method of manufacturing the system of claim 11, further comprising:
attaching anechoic material to a ferrous surface of a testing structure held by the apparatus.

## Patentansprüche

1. System, umfassend:
echofreies Material, das ein Substrat bildet;
eine Teststruktur (600), die aus einem ferromagnetischen Material gebildet ist; und
eine Einrichtung (100), die abnehmbar mit dem echofreien Material (500) gekoppelt ist, wobei die Einrichtung durch das echofreie Material hindurch angeordnet ist, um das echofreie Material an einer eisenhaltigen Oberfläche zu halten, wobei die Einrichtung eine Basis (101) umfasst;
einen Rückhaltemechanismus (107), der mit der Basis gekoppelt ist; und
einen Befestigungsmechanismus (103), der mit der Basis gekoppelt ist, wobei der Befestigungsmechanismus dazu dient, die Einrichtung abnehmbar an einer eisenhaltigen Wand zu befestigen,
wobei der Rückhaltemechanismus und der Befestigungsmechanismus zusammen gestaltet sind, um das echofreie Material an einer Oberfläche der Teststruktur an Ort und Stelle zu halten.

2. System nach Anspruch 1, weiter umfassend:
einen Ablösemechanismus (109), der mit der Basis gekoppelt ist.

3. System nach Anspruch 1, wobei der Befestigungsmechanismus ein Magnet ist.

4. System nach Anspruch 1, wobei der Rückhaltemechanismus ein Satz von Zinken ist, die eine an der Basis zentrierte Kreuzform aufweisen.

5. System nach Anspruch 4, weiter umfassend:
einen Zinkenverlängerer, der mit mindestens einem Zinken in dem Satz von Zinken gekoppelt ist, wobei es der Zinkenverlängerer ermöglichen soll, die Einrichtung mit einem Zinken einer anderen Einrichtung zu koppeln.

6. System nach Anspruch 1, wobei die Basis und der Rückhaltemechanismus aus einem Nichteisenmaterial gebildet sind.

7. System nach Anspruch 1, wobei die Basis ein Gewinde definiert, um den Befestigungsmechanismus aufzunehmen.

8. System nach Anspruch 1, wobei die Basis einen Raum definiert, um den Befestigungsmechanismus innerhalb der Basis zu halten.

9. System nach Anspruch 1, wobei die Basis konisch, mit einer an einem Ende abgerundeten Kuppel ist.

10. System nach Anspruch 2, wobei der Ablösemechanismus eine Schlaufe ist, die mit der Basis gekoppelt ist.

11. Verfahren zum Herstellen des Systems nach den vorstehenden Ansprüchen, wobei das Verfahren umfasst:
Bilden der Basis (101) und des Rückhaltemechanismus (107) durch Spritzgießen.

12. Verfahren zum Herstellen des Systems nach Anspruch 11, weiter umfassend:
Einsetzen einer Messingstruktur mit Gewinde in einen Innenraum der Basis durch Vibrationsprozess.

13. Verfahren zum Herstellen des Systems nach Anspruch 11, weiter umfassend:
Befestigen von echofreiem Material an einer eisenhaltigen Oberfläche einer Teststruktur, die von der Einrichtung gehalten wird.

## Revendications

1. Système, comprenant :
un matériau anéchoïque formant un substrat ;
une structure de test (600) formée d'un matériau ferromagnétique ; et
un appareil (100) couplé de manière amovible au matériau anéchoïque (500), l'appareil étant disposé à travers le matériau anéchoïque pour maintenir le matériau anéchoïque sur une surface ferreuse, l'appareil comprenant une base (101) ;
un mécanisme de retenue (107) couplé à la base ; et
un mécanisme de fixation (103) couplé à la base, le mécanisme de fixation permettant de fixer de manière amovible l'appareil à une paroi ferreuse,
dans lequel le mécanisme de retenue et le mécanisme de fixation sont conçus ensemble pour maintenir le matériau anéchoïque en place contre une surface de la structure de test.

2. Système selon la revendication 1, comprenant en outre :
un mécanisme de détachement (109) couplé à la base.

3. Système selon la revendication 1, dans lequel le mécanisme de fixation est un aimant.

4. Système selon la revendication 1, dans lequel le mécanisme de retenue est un ensemble de dents présentant une forme de croix centrée au niveau de la base.

5. Système selon la revendication 4, comprenant en outre :
un prolongateur de dent couplé à au moins une dent de l'ensemble de dents, le prolongateur de dent permettant à l'appareil d'être couplé à une dent d'un autre appareil.

6. Système selon la revendication 1, dans lequel la base et le mécanisme de retenue sont formés d'un matériau non ferreux.

7. Système selon la revendication 1, dans lequel la base définit un filetage pour recevoir le mécanisme de fixation.

8. Système selon la revendication 1, dans lequel la base définit un espace pour maintenir le mécanisme de fixation à l'intérieur de la base.

9. Système selon la revendication 1, dans lequel la base est conique avec un dôme arrondi au niveau d'une extrémité.

10. Système selon la revendication 2, dans lequel le mécanisme de détachement est une boucle couplée à la base.

11. Procédé de fabrication du système selon les revendications précédentes, le procédé comprenant :
la formation de la base (101) et du mécanisme de retenue (107) par moulage par injection.

12. Procédé de fabrication du système selon la revendication 11, comprenant en outre :
l'insertion d'une structure filetée en laiton dans un espace intérieur de la base par un processus de vibrations.

13. Procédé de fabrication du système selon la revendication 11, comprenant en outre :
la fixation d'un matériau anéchoïque sur une surface ferreuse d'une structure de test maintenue par l'appareil.
